# EUROPÄISCHE PATENTSCHRIFT

(11) **EP 0 496 215 B1**
(45) Veröffentlichungstag und Bekanntmachung des Hinweises auf die Patenterteilung: **30.08.1995**
(21) Anmeldenummer: 92100278.8
(22) Anmeldetag: 09.01.1992
(51) Int. Cl.: H01L 39/24

(54) **Verfahren zur Herstellung eines strukturierten Aufbaus mit Hochtemperatursupraleitermaterial**
Method of making a structured design using high-temperature superconducting material
Méthode pour la formation d'un concept structural avec matériau supraconducteur à haute température

(30) Priorität: 21.01.1991 DE 4101604
(43) Veröffentlichungstag der Anmeldung: 29.07.1992
(73) Patentinhaber: SIEMENS AKTIENGESELLSCHAFT, 80333 München (DE)
(72) Erfinder: Roas, Bernhard, Dr., W-8520 Erlangen (DE)

(56) Entgegenhaltungen:
- US-A- 4 218 532
- US-A- 4 459 321
- US-A- 4 913 769
- APPLIED PHYSICS LETTERS, Bd. 59, Nr. 20, 11. November 1991, New York, US, Seiten 2594-2596, B. Roas: "Patterning of epitaxial YBa2Cu30x insulator multilayers with a high-temperature-resistant lift-off mask"
- APPLIED PHYSICS LETTERS Bd. 56, Nr. 14, 2. April 1990, New York, US, Seiten 1374-1376; J.R. Phillips et al.: "Vapor-deposited superconducting YBa2Cu307-d lines : Effect of thickness and width on morphology"
- PHYSICA C, vol. 185-189, Pt. 4, December 1991, pages 2595-2596, Amsterdam, NL; B. Roas et al.: "Basic elements of high temperature superconductor wiring" & CONFERENCE ON MATERIALS AND MECHANISMS OF SUPERCONDUCTIVITY III, 22-26 July 1991, Kanazawa, JP

## Beschreibung

Die Erfindung bezieht sich auf ein Verfahren zur Herstellung einer strukturierten Schicht aus einem ersten Material mit mindestens einer Aussparung mit vorgegebener geometrischer Gestalt auf einem gegebenenfalls strukturierten Unterbau aus mindestens einem zweiten Material, wobei eines der Materialien ein metalloxidisches Supraleitermaterial mit hoher Sprungtemperatur ist, das gegenüber säurehaltigen Lösungsmitteln empfindlich ist, und wobei das erste Material bei einer erhöhten Abscheidetemperatur zwischen 150°C und 1000°C auf dem Unterbau in einer sauerstoffhaltigen Atmosphäre aufzubringen ist. Ein derartiges Verfahren geht zum Beispiel aus der DE-OS 38 22 905 hervor.

Supraleitende Metalloxidverbindungen mit hohen Sprungtemperaturen T_{c} von insbesondere über 77 K, die deshalb mit flüssigem Stickstoff gekühlt werden können, sind seit einigen Jahren allgemein bekannt. Entsprechende Hochtemperatursupraleiter-Materialien - nachfolgend als "HTSL-Materialien" bezeichnet - basieren beispielsweise auf einem mindestens vierkomponentigen Stoffsystem des Typs Me1-Me2-Cu-0, wobei die Komponenten Me1 ein Seltenes Erdmetall einschließlich Yttrium und Me2 ein Erdalkalimetall zumindest enthalten. Hauptvertreter dieser Gruppe ist das Stoffsystem Y-Ba-Cu-0. Daneben weisen auch Phasen von fünfkomponentigen Cupraten wie z.B. des Stoffsystems Bi-Sr-Ca-Cu-0 oder Tl-Ba-Ca-Cu-0 Sprungtemperaturen T_{c} über 77 K auf.

Zu einer Herstellung von mehrlagigen Strukturen mit Dünnfilmen aus den bekannten HTSL-Materialien ist es erforderlich, strukturierte Isolatorschichten und/oder strukturierte HTSL-Schichten auf einem hierfür geeigneten Unterbau ohne Beschädigung des jeweiligen HTSL-Materials unter Einhaltung von Bedingungen für eine Epitaxie oder zumindest eine Texturierung ausbilden zu können. Bekannte, für HTSL-Materialien geeignete Isolatormaterialien sind z.B. SrTiO₃, LaAlO₃, NdGaO₃, MgO oder ZrO₂. Eine Strukturierung einer entsprechenden Isolatorschicht, die bei hoher Temperatur von z.B. 800°C epitaktisch auf einer HTSL-Schicht aufwächst, ist mit chemischen oder physikalischchemischen Verfahren wie z.B. durch naßchemisches Ätzen oder reaktives Ionenätzen praktisch nicht möglich. Denn alle bisher bekannten Ätzmittel, die das Isolatormaterial angreifen, zerstören auch das HTSL-Material. So ist z.B. das bekannte Y-Ba-Cu-O-Supraleitermaterial gegenüber Säuren so empfindlich, daß es mit Phosphorsäure in einer Konzentration Säure/Wasser von 1/100 naßchemisch strukturiert werden kann. Außerdem lassen sich alle für die HTSL-Technik bekannten epitaxiefähigen Isolatormaterialien auch in konzentrierten Säuren nur schwer oder gar nicht auflösen.

Man hat deshalb versucht, Isolatorschichten mittels Ionenstrahlätzens zu strukturieren. Bei einem solchen Verfahren kann man jedoch nur aufwendig kontrollieren, nach welcher Ätzzeit das HTSL-Material freigelegt ist. Außerdem ist dieses Ätzverfahren auch nur dann anwendbar, wenn die Isolatorschicht überall gleiche Dicke aufweist. Ferner können nur ionenstrahlresistente Ätzmasken, insbesondere aus Metall, eingesetzt werden. Darüber hinaus ist der technische Aufwand für den Strukturierungsschritt verhältnismäßig groß, da in einer Hochvakuumkammer mit einem großflächigen Ionenstrahl gearbeitet werden muß.

Ferner ist z.B. aus der eingangs genannten DE-OS 38 22 905 bekannt, das Isolatormaterial durch eine auf das HTSL-Material aufzubringende, quasi schwebende Prozeßmaske aufzudampfen. Hierbei muß die Maske sehr genau im »m-Bereich fixiert werden und darf auch bei hohen thermischen Belastungen wie den erforderlichen Temperaturdurchläufen zwischen Raumtemperatur und etwa 800°C nicht verrutschen oder beschädigt werden. Da aufliegende Masken lokal die Temperatur der darunterliegenden Schicht verändern können, sind Wärmestauprobleme nicht auszuschließen, die zu einer Zerstörung eines HTSL-Filmes führen können.

Aufgabe der vorliegenden Erfindung ist es deshalb, ein Verfahren mit den eingangs genannten Merkmalen anzugeben, mit dem auf einem vorgegebenen, gegebenenfalls strukturierten Unterbau der HTSL-Technik eine strukturierte Schicht aus einem HTSL-Material oder aus einem Isolatormaterial herzustellen ist, ohne daß es zu einer Schädigung oder Zerstörung des HTSL-Materials kommt.

Diese Aufgabe wird erfindungsgemäß dadurch gelöst,
1.) daß zunächst auf dem Unterbau eine in einem diesen Unterbau nicht-angreifenden ersten Lösungsmittel lösliche Lackschicht mit einer Struktur aufgebracht wird, die der Struktur der aus dem ersten Material herzustellenden Schicht entspricht,
2.) daß dann auf diesem Aufbau kalt eine Hilfsschicht aus einem dritten Material abgeschieden wird, das in einem zweiten, das erste und zweite Material nicht-angreifenden Lösungsmittel löslich ist, von dem ersten Lösungsmittel selbst nicht angegriffen wird und bei der erhöhten Abscheidetemperatur für das erste Material keine Reaktion mit dem ersten und dem zweiten Material eingeht und selbst entsprechend temperaturfest ist,
3.) daß darauf die Lackschicht mit dem daraufliegenden Teil der Hilfsschicht mittels des ersten Lösungsmittels entfernt wird,
4.) daß anschließend der so erhaltene Aufbau bei der erhöhten Abscheidetemperatur mit einer Überzugsschicht aus dem ersten Material versehen wird und
5.) daß schließlich in dem Bereich der mindestens einen Aussparung der dort verbliebene Teil der Hilfsschicht mit dem daraufliegenden Teil der Überzugsschicht mittels des zweiten Lösungsmittels entfernt wird.

Die mit dieser Ausgestaltung des Verfahrens verbundenen Vorteile sind insbesondere darin zu sehen, daß gemäß einer bekannten, sogenannten Lift-off-Technik zur naßchemischen Entfernung der Lackschicht mit darauf befindlichem Teil der Hilfsschicht sowie zur naßchemischen Entfernung des in der vorgegebenen Aussparung verbliebenen Teils der Hilfsschicht mit dem darauf befindlichen Teil der Überzugsschicht beliebige Strukturen mit HTSL- und/oder Isolatormaterialien herzustellen sind, ohne daß das HTSL-Material angegriffen wird. Insbesondere ist nunmehr unter Verwendung von ersten Materialien, die auf zweiten Materialien nur bei hohen Temperaturen von bis zu 1000°C aufzubringen sind, eine Möglichkeit zur Ausbildung von mehrlagigen Strukturen geschaffen, wie sie Schaltungen oder Schaltungsteile mit HTSL-Dünnfilmen darstellen.

Vorteilhafte Ausgestaltungen des erfindungsgemäßen Verfahrens gehen aus den Unteransprüchen hervor.

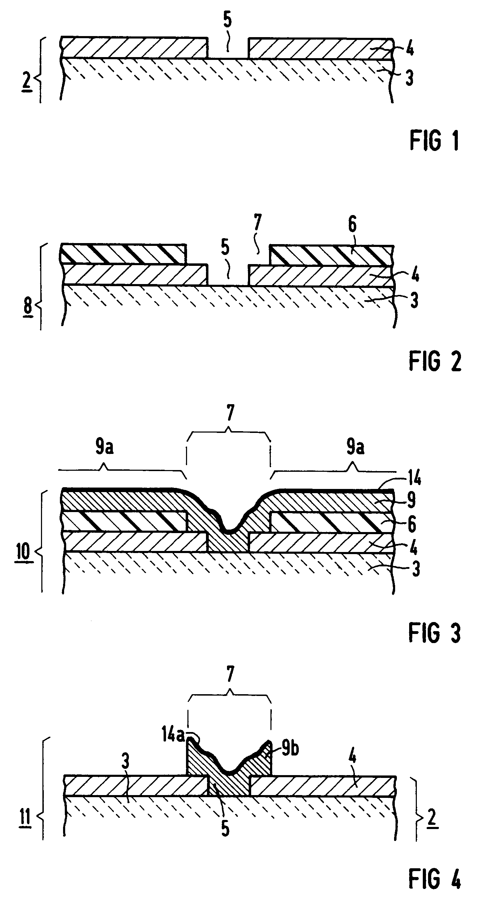

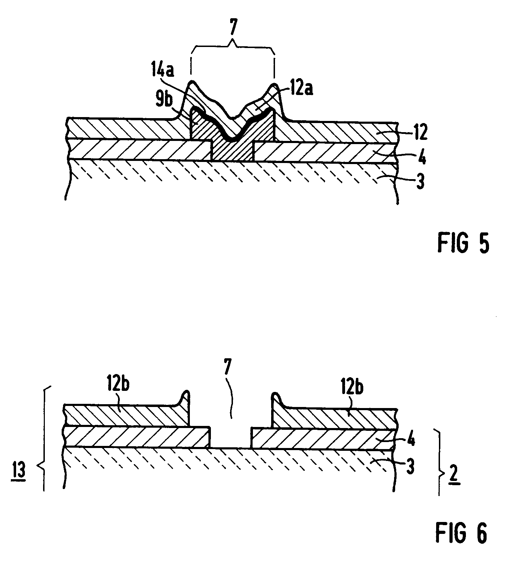

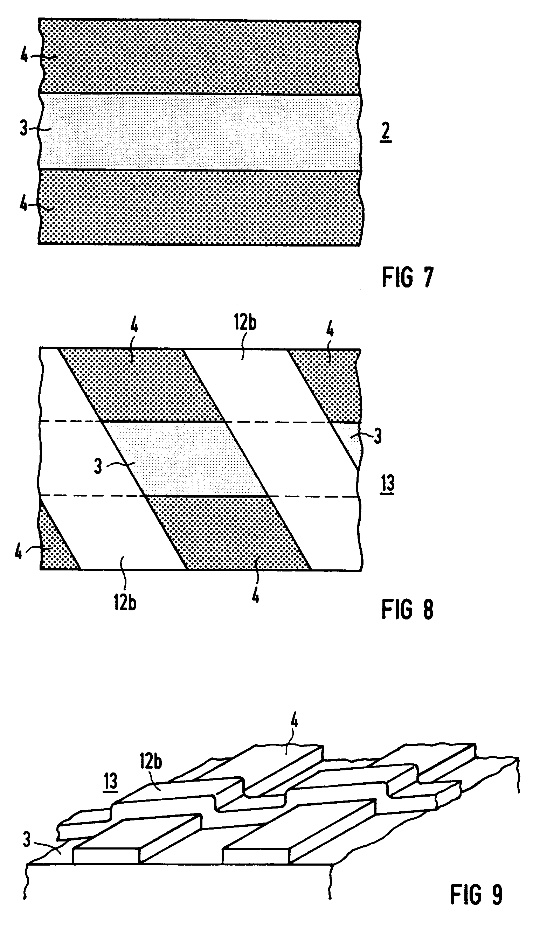

Zur weiteren Erläuterung der Erfindung wird nachfolgend auf die Zeichnung Bezug genommen, in deren Figuren 1 bis 6 schematisch einzelne Verfahrensschritte zur Herstellung einer strukturierten Schicht aus einem Isolatormaterial auf einer strukturierten Schicht aus einem HTSL-Material als Querschnitte veranschaulicht sind. In den Figuren 7 und 8 sind die entsprechenden Aufsichten zu Figur 1 bzw. zu Figur 6 wiedergegeben. Figur 9 zeigt die entsprechende Schrägansicht zur Figur 8. Dabei sind in den Figuren sich entsprechende Teile mit denselben Bezugszeichen versehen.

Mit dem erfindungsgemäßen Verfahren soll auf einem Unterbau eine strukturierte Schicht aus einem vorbestimmten ersten Material in einer sauerstoffhaltigen Atmosphäre, wie sie zur Ausbildung bekannter HTSL-Materialien erforderlich ist, hergestellt werden. Das erste Material soll dabei nur bei hohen Temperaturen aufzubringen sein. Gemäß dem gewählten Ausführungsbeispiel kann es sich bei dem für Figur 1 angenommenen, allgemein mit 2 bezeichneten Unterbau um ein bekanntes Substrat 3 handeln, auf dem in bekannter Weise in Dünnfilm-Technik eine HTSL-Schicht 4 ausgebildet ist. Für das Substrat läßt sich insbesondere ein Isolatormaterial vorsehen, auf dem epitaktisch das bei dem erfindungsgemäßen Verfahren als zweites Material bezeichnete HTSL-Material wie z.B. YBa₂Cu₃O₇₋ₓ (mit 0,5 < x < 1) aufwachsen kann. Entsprechende Isolatormaterialien, deren jeweilige Einheitszelle vorteilhaft an die Abmessungen der Einheitszelle des verwendeten HTSL-Materials angepaßte Abmessungen hat, sind z.B. SrTiO₃, LaAlO₃, NdGaO₃, MgO oder Y-stabilisiertes ZrO₂. Das HTSL-Material der Schicht 4 kann gegebenenfalls strukturiert sein, so daß das Substrat 3 in einer Ausnehmung 5 nicht mit dem HTSL-Material bedeckt ist.

Auf diesem Unterbau wird gemäß Figur 2 zunächst eine Lackschicht 6 aufgebracht. Diese Lackschicht soll so strukturiert werden, daß ihre Konturen denen der mit dem erfindungsgemäßen Verfahren letztlich herzustellenden Schicht aus dem ersten Material entspricht. Hierzu ist insbesondere ein Photolack geeignet, der mittels bekannter Maskentechnik auf dem Unterbau 2 strukturiert ist. Gemäß Figur 2 enthält deshalb die Lackschicht 6 mindestens eine Aussparung 7, in deren Bereich der Unterbau 2 frei von dem Lackmaterial ist. Die Aussparung 7 kann dabei auch den Bereich der Ausnehmung 5 mit umfassen, so daß dort die Oberfläche des Substrates 3 freiliegt. Das zu verwendende Lackmaterial der Schicht 6 soll in einem ersten Lösungsmittel lösbar sein, das die Materialien des Unterbaus 2 nicht angreift. Ein entsprechendes erstes Lösungsmittel ist z.B. Aceton.

Auf dem so gewonnenen, allgemein mit 8 bezeichneten Aufbau wird dann gemäß Figur 3 kalt eine Hilfsschicht 9 aus einem vorbestimmten dritten Material abgeschieden. Dieses dritte Material muß eine Reihe von Bedingungen erfüllen:
a) Es muß in einem zweiten Lösungsmittel löslich sein, welches das erste (Isolator)-Material sowie das zweite (HTSL)-Material nicht angreift.
b) Ferner darf es von dem ersten Lösungsmittel (Aceton) selbst nicht angegriffen werden.
c) Schließlich soll es bei einer erhöhten Temperatur zwischen 150°C und 1000°C, bei der das erste Material der herzustellenden Schicht nur abgeschieden werden kann, keine Reaktion sowohl mit dem ersten Material als auch mit dem zweiten (HTSL)-Material eingehen. Selbstverständlich muß das dritte Material auch bezüglich dieser hohen Abscheidetemperatur hinreichend stabil sein, d.h., es darf sich dabei nicht zersetzen.

Entsprechende dritte Materialien, die diesen Bedingungen genügen, sind insbesondere in Wasser oder in schwachen Laugen wie z.B. verdünnte KOH-Lauge oder verdünnte NaOH-Lauge lösliche Metalloxide wie z.B. CaO oder SrO. Dabei sind solche dritte Materialien zu bevorzugen, deren metallische Komponente nicht auch als Komponente des HTSL-Materials auftritt. Aus diesem Grunde ist CaO für das HTSL-Material YBa₂Cu₃O₇₋ₓ besonders geeignet.

Da auf die Hilfsschicht 9 insbesondere aus CaO in nachfolgenden Schritten direkt das HTSL-Material wie YBa₂Cu₃O₇₋ₓ oder SrTiO₃ oder LaAlO₃ in heißem Zustand aufgedampft werden soll und diese Materialien nicht bis zum Substrat 3 hindurchdiffundieren sollten, kann die Hilfsschicht 9 gegebenenfalls noch mit einer weiteren dünnen Schicht 14 insbesondere aus einem Metall oder Metalloxid versiegelt werden. Für diese in der Figur 3 durch eine verstärkte Linie angedeutete Versiegelungsschicht 14 bieten sich insbesondere Zr oder ZrO₂ an. Zum Beispiel kann eine Zr-Schicht sehr schön eine etwas rauhe CaO-Oberfläche abschließen. Das Zr wird bei einem O₂-Druck von beispielsweise 0,4 mbar und 800 °C zum ZrO₂ oxidiert.

Anschließend wird die strukturierte Lackschicht mit dem daraufliegenden Teil 9a der Hilfsschicht 9 nach einer sogenannten Lift-off-Technik entfernt. Hierzu wird der gesamte Schichtaufbau 10 dem ersten Lösungsmittel (Aceton) für das Lackmaterial der Schicht 6 ausgesetzt. Dieses Lösungsmittel löst nur die Lackschicht 6 auf, wobei der bisher daraufliegende Hilfsschichtteil 9a mit weggenommen wird. Gefördert wird dieser Lift-off durch Anwendung von Ultraschallwellen auf das verwendete Bad des ersten Lösungsmittels. Es ergibt sich so ein in Figur 4 gezeigter Aufbau 11 aus dem Unterbau 2 mit einem den Bereich der bisherigen Aussparung 7 und die Ausnehmung 5 ausfüllenden Restteil 9b der Hilfsschicht 9 sowie mit einer außerhalb der bisherigen Aussparung 7 freigelegten Oberfläche der Schicht 4 aus dem zweiten (HTSL)-Material. Der Restteil 9b der Hilfsschicht 9 kann dabei gegebenenfalls von einem entsprechenden Restteil 14a der Versiegelungsschicht 14 abgedeckt sein.

Dieser Aufbau wird nun gemäß Figur 5 mit einer Schicht 12 aus dem gewünschten ersten Material überzogen. Für das Material dieser Überzugsschicht 12 sei gemäß dem gewählten Ausführungsbeispiel wiederum ein Isolatormaterial wie z.B. für das Substrat 3 gewählt. Das Isolatormaterial sollte vorzugsweise epitaktisch auf dem zweiten (HTSL)-Material der Schicht 4 aufwachsen können. Entsprechende Isolatormaterialien wie z.B. LaAlO₃ lassen sich nur bei erhöhten Temperaturen oberhalb von 150°C, z.B. oberhalb von 400°C bis zu gegebenenfalls 1000°C abscheiden. Die Abscheidetemperatur darf vorteilhaft bei dem erfindungsgemäßen Verfahren so hoch sein, da die Materialien des Unterbaus 2 sowie das vorbestimmte dritte Material des Restteils 9b der Hilfsschicht 9 bei diesen Temperaturen keine Reaktionen miteinander eingehen.

Schließlich werden in einem weiteren Lift-off-Schritt der im Bereich der bisherigen Aussparung 7 befindliche Restteil 9b der Hilfsschicht 9 sowie der darüberliegende Teil 12a der Überzugsschicht 12 aus dem ersten (Isolator-)Material mit dem zweiten, das Material der Hilfsschicht lösenden Lösmittel Wasser oder verdünnter Lauge entfernt. Auch hierbei kann vorteilhaft Ultraschall eingesetzt werden. Das zweite Lösungsmittel greift dabei das HTSL-Material (zweites Material) sowie das Isolatormaterial (erstes Material) nicht an. In Figur 6 ist der sich so ergebende Aufbau mit der gewünschten strukturierten Schicht 12b aus dem Isolatormaterial auf der Schicht 4 aus dem HTSL-Material wiedergegeben und allgemein mit 13 bezeichnet.

Auf diesen Aufbau 13 können nun entsprechend dem vorstehend geschilderten Verfahren nach der Erfindung weitere strukturierte Schichten aus einem HTSL-Material bzw. Isolatormaterial aufgebracht werden. Auf diese Weise lassen sich z.B. supraleitende Mehrlagenverdrahtungen unter Verwendung von HTSL-Material einschließlich Durchkontaktierungen und Kreuzungen von Supraleiterbahnen sowie Isolatorkanten zur Erzeugung von sogenannten "Weak Links" mit HTSL-Material (vgl. z.B. DE-OS 38 22 904) herstellen.

Zur weiteren Veranschaulichung des erfindungsgemäßen Verfahrens sind in Figur 7 ein Ausschnitt des Unterbaus 2 (gemäß Figur 1) und in Figur 8 ein Ausschnitt des am Ende des erfindungsgemäßen Verfahrens ausgebildeten Aufbaus 13 (gemäß Figur 6) jeweils als Aufsicht gezeigt. In Figur 9 ist eine Schrägansicht auf den Ausschnitt des Aufbaus 13 (gemäß Figur 8) dargestellt.

Gemäß dem ausgewählten Ausführungsbeispiel wurde angenommen, daß es sich bei dem Unterbau 2 um eine gegebenenfalls strukturierte HTSL-Schicht 4 auf einem hierfür geeigneten Substrat 3 handelt. Selbstverständlich kann für das erfindungsgemäße Verfahren von einem anderen Unterbau ausgegangen werden, der beispielsweise zumindest an seiner zu beschichtenden Oberseite lediglich ein gegebenenfalls noch strukturiertes Isolatormaterial als zweites Material aufweist oder das Substrat selbst ist.

## Patentansprüche

1. Verfahren zur Herstellung einer strukturierten Schicht aus einem ersten Material mit mindestens einer Aussparung mit vorgegebener geometrischer Gestalt auf einem gegebenenfalls strukturierten Unterbau aus mindestens einem zweiten Material, wo bei
- eines der Materialien ein metalloxidisches Supraleitermaterial mit hoher Sprungtemperatur ist, das gegenüber säurehaltigen Lösungsmitteln empfindlich ist,
und
- das erste Material bei einer erhöhten Abscheidetemperatur zwischen 150°C und 1000°C auf dem Unterbau in einer sauerstoffhaltigen Atmosphäre aufzubringen ist,
**dadurch gekennzeichnet,**
1.) daß zunächst auf dem Unterbau (2) eine in einem diesen Unterbau nicht-angreifenden ersten Lösungsmittel lösliche Lackschicht (6) mit einer Struktur aufgebracht wird, die der Struktur der aus dem ersten Material herzustellenden Schicht (12b) entspricht,
2.) daß dann auf diesem Aufbau (8) kalt eine Hilfsschicht (9) aus einem dritten Material abgeschieden wird, das
a) in einem zweiten, das erste und zweite Material nichtangreifenden Lösungsmittel löslich ist,
b) von dem ersten Lösungsmittel selbst nicht angegriffen wird und
c) bei der erhöhten Abscheidetemperatur für das erste Material keine Reaktion mit dem ersten und dem zweiten Material eingeht und selbst entsprechend temperaturfest ist,
3.) daß darauf die Lackschicht (6) mit dem daraufliegenden Teil (9a) der Hilfsschicht (9) mittels des ersten Lösungsmittels wieder entfernt wird,
4.) daß anschließend der so erhaltene Aufbau (11) bei der erhöhten Abscheidetemperatur mit einer Überzugsschicht (12) aus dem ersten Material versehen wird
und
5.) daß schließlich in dem Bereich der mindestens einen Aussparung (7) der dort verbliebene Teil (9b) der Hilfsschicht (9) mit dem daraufliegenden Teil (12a) der Überzugsschicht (12) mittels des zweiten Lösungsmittels entfernt wird.

2. Verfahren nach Anspruch 1, **dadurch gekennzeichnet,** daß die Hilfsschicht (9) vor dem Entfernen der Lackschicht (9) und des Hilfsschichtteils (9a) mit einer Versiegelungsschicht (14), insbesondere aus einem Metall oder Metalloxid, überzogen wird.

3. Verfahren nach Anspruch 1 oder 2, **dadurch gekennzeichnet,** daß die Lackschicht (6) mit dem daraufliegenden Teil (9a) der Hilfsschicht (9) und/oder der im Bereich der mindestens einen Aussparung (7) verbliebene Teil (9b) der Hilfsschicht (9) mit dem daraufliegenden Teil (12a) der Überzugsschicht (12) gemäß einer bekannten Lift-off-Technik entfernt werden.

4. Verfahren nach Anspruch 3, **dadurch gekennzeichnet,** daß bei der Lift-off-Technik zum Entfernen der jeweils daraufliegenden Teile (9a, 12a) zusätzlich Ultraschallwellen angewandt werden.

5. Verfahren nach einem der Ansprüche 1 bis 4, **dadurch gekennzeichnet,** daß als Material für die Lackschicht (6) ein Photolack vorgesehen wird.

6. Verfahren nach einem der Ansprüche 1 bis 5, **dadurch gekennzeichnet,** daß als erstes Lösungsmittel Aceton vorgesehen wird.

7. Verfahren nach einem der Ansprüche 1 bis 6, **dadurch gekennzeichnet,** daß als Material für die Hilfsschicht (9) ein in Wasser oder in einer schwachen Lauge lösliches Metalloxid vorgesehen wird.

8. Verfahren nach Anspruch 7, **dadurch gekennzeichnet,** daß ein Metalloxid vorgesehen wird, dessen metallische Komponente nicht als Komponente des Supraleitermaterials auftritt.

9. Verfahren nach Anspruch 7 oder 8, **dadurch gekennzeichnet,** daß als Material für die Hilfsschicht (9) CaO oder SrO vorgesehen wird.

10. Verfahren nach einem der Ansprüche 1 bis 9, **dadurch gekennzeichnet,** daß als erstes oder zweites Material ein Isolatormaterial vorgesehen wird, das eine zumindest texturierte Ausbildung des darauf aufzubringenden Supraleitermaterials ermöglicht.

11. Verfahren nach Anspruch 10, **dadurch gekennzeichnet,** daß als Isolatormaterial eines der Materialien aus der Gruppe SrTiO₃, LaAlO₃, NdGaO₃, MgO oder ZrO₂ vorgesehen wird.

## Claims

1. Method for producing a structured layer out of a first material having at least one recess with a given geometrical shape on a substructure, which, if applicable, is structured and consists of at least one second material, wherein
- one of the materials is a metal oxide superconductor material which has a high transition temperature and is sensitive to solvents containing acid, and
- the first material is to be applied to the substructure in an atmosphere which contains oxygen at a raised deposition temperature of between 150°C and 1000°C,
characterised in that
1.) first there is applied to the substructure (2) a layer of varnish (6) which is soluble in a first solvent that does not attack this substructure and which has a structure which corresponds to the structure of the layer (12b) to be produced out of the first material,
2.) then in the cold state there is deposited on this built-up structure (8) an auxiliary layer (9) consisting of a third material which
a) is soluble in a second solvent that does not attack the first material and the second material,
b) is itself not attacked by the first solvent, and
c) at the raised deposition temperature for the first material does not react with the first material and the second material and is itself correspondingly thermostable,
3.) after that the varnish layer (6) with the part (9a) of the auxiliary layer (9) resting thereon is removed by means of the first solvent,
4.) subsequently at the raised deposition temperature the built-up structure (11) thus obtained is provided with a coating layer (12) consisting of the first material, and
5.) finally, in the area of the at least one recess (7) the part (9b) of the auxiliary layer (9) which remains there with the part (12a) of the coating layer (12) resting thereon is removed by means of the second solvent.

2. Method according to claim 1, characterised in that before removal of the varnish layer (9) (sic) and the auxiliary layer part (9a) the auxiliary layer (9) is coated with a sealing layer (14), in particular consisting of a metal or metal oxide.

3. Method according to claim 1 or 2, characterised in that the varnish layer (6) with the part (9a) of the auxiliary layer (9) resting thereon and/or the part (9b) of the auxiliary layer (9) remaining in the area of the at least one recess (7) with the part (12a) of the coating layer (12) resting thereon are removed according to a known lift-off technique.

4. Method according to claim 3, characterised in that in the case of the lift-off technique, in addition, ultrasonic waves are used to remove the respective parts (9a, 12a) resting thereon.

5. Method according to one of the claims 1 to 4, characterised in that a photo-resist is provided as a material for the varnish layer (6).

6. Method according to one of the claims 1 to 5, characterised in that acetone is provided as the first solvent.

7. Method according to one of the claims 1 to 6, characterised in that a metal oxide which is soluble in water or in a weak base is provided as a material for the auxiliary layer (9).

8. Method according to claim 7, characterised in that a metal oxide is provided, the metallic component of which metal oxide does not occur as a component of the superconductor material.

9. Method according to claim 7 or 8, characterised in that CaO or SrO is provided as a material for the auxiliary layer (9).

10. Method according to one of the claims 1 to 9, characterised in that an insulator material is provided as a first material or a second material which renders possible an at least textured formation of the superconductor material to be applied thereto.

11. Method according to claim 10, characterised in that one of the materials from the group SrTiO₃, LaAlO₃, NdGaO₃, MgO or ZrO₂ is provided as the insulator material.

## Revendications

1. Méthode pour la formation d'une couche structurée faite d'un premier matériau avec au moins un évidement d'une forme prédéfinie géométrique sur une base éventuellement structurée faite d'au moins un deuxième matériau,
- l'un des matériaux étant un supraconducteur d'oxyde métallique à haute température de changement brusque de la conductivité, sensible aux solvants acides,
et
- le premier matériau devant être appliqué sur la base à une température de dépôt élevée variant entre 150°C et 1000°C dans une atmosphère oxygénée,
caractérisée
1) en ce qu'une couche de laque (6) soluble dans un premier solvant n'attaquant pas cette base, est d'abord appliquée sur la base (2) avec une structure, qui correspond à la structure de la couche (12b) à former à partir du premier matériau,
2) en ce qu'une couche auxiliaire (9) faite d'un troisième matériau, est ensuite déposée à froid sur ce concept (8),
a) ce troisième matériau étant soluble dans un deuxième solvant n'attaquant pas le premier ni le second matériau,
b) et n'est pas attaqué par le premier solvant lui-même
et
c) n'entre pas en réaction à la température élevée de dépôt du premier matériau ni avec le premier ni avec le second matériau et est même en conséquence thermostable,
3) en ce qu'ensuite la couche de laque (6) est à nouveau enlevée avec la partie (9a) de la couche auxiliaire (9) située au-dessus au moyen du premier solvant,
4) en ce qu'ensuite le concept (11) ainsi obtenu est doté, à la température de dépôt élevée, d'une couche de revêtement (12) faite du premier matériau
et
5) en ce qu'enfin dans la zone d'au moins un évidement (7), la partie (9b) de la couche auxiliaire (9) restant à cet endroit est enlevée avec la partie (12a) de la couche de revêtement (12) située au-dessus, au moyen du deuxième solvant.

2. Méthode selon la revendication 1, caractérisée en ce que la couche auxiliaire (9) est revêtue d'une couche pour sceller (14), en particulier en métal ou en oxyde métallique, avant d'enlever la couche de laque (6) et la partie de couche auxiliaire (9a).

3. Méthode selon la revendication 1 ou 2, caractérisée en ce que la couche de laque (6) avec la partie située au-dessus (9a) de la couche auxiliaire (9) et/ou la partie (9b) de la couche auxiliaire (9) restant dans la zone d'au moins un évidement (7) avec la partie (12a) de la couche de revêtement (12) située au-dessus, est enlevée selon une technique d'enlèvement connue.

4. Méthode selon la revendication 3, caractérisée en ce qu'on utilise en complément de la technique d'enlèvement destinée à éliminer les parties respectivement situées dessus (9a,12a), des ondes ultrasoniques.

5. Méthode selon les revendications 1 à 4, caractérisée en ce qu 'une laque photosensible est prévue comme matériau destiné à la couche de laque (6).

6. Méthode selon les revendications 1 à 5, caractérisée en ce que l'acétone est prévu comme premier solvant.

7. Méthode selon les revendications 1 à 6, caractérisée en ce qu 'un oxyde métallique hydrosoluble ou soluble dans une base faible, est prévu comme matériau pour la couche auxiliaire (9).

8. Méthode selon la revendication 7, caractérisée en ce qu 'un oxyde métallique est prévu dont la composante métallique n'entre pas comme composante du matériau supraconducteur.

9. Méthode selon la revendication 7 ou 8, caractérisée en ce que le CaO, ou le SrO, est prévu comme matériau de la couche auxiliaire (9).

10. Méthode selon l'une quelconque des revendications 1 à 9, caractérisée en ce qu'un matériau isolant est prévu comme premier ou second matériau, permettant une formation au moins texturée du matériau supraconducteur à appliquer dessus.

11. Méthode selon la revendication 10, caractérisée en ce qu 'on a prévu un des matériaux du groupe SrTiO₃, LaAIO₃, NdGaO₃, MgO ou ZrO₂ comme matériau isolant.
